# EUROPÄISCHE PATENTANMELDUNG

(11) **EP 3 879 007 A1**
(43) Veröffentlichungstag der Anmeldung: **15.09.2021**
(21) Anmeldenummer: 20198675.9
(22) Anmeldetag: 28.09.2020
(51) Int. Cl.: C25D 5/34, C23C 14/00, C23C 28/00, C25D 7/00

(54) **VERFAHREN ZUR HERSTELLUNG EINES BESCHICHTETEN BAUTEILS**

(30) Priorität: 09.03.2020 DE 102020106256
(71) Anmelder: Grohe AG, 58653 Hemer (DE)
(72) Erfinder: ZIMMERMANN, Christian, 58675 Hemer (DE)

(57) **Zusammenfassung**

Die Erfindung betrifft ein Verfahren zur Herstellung eines beschichteten Bauteils (1), umfassend zumindest folgende Schritte:
a) Bereitstellen eines Substrates (2) für das Bauteil (1),
b) Bereitstellen eines Halbzeugs (3) für das Bauteil (1), durch Aufbringen eines Materials (4) auf zumindest einen Teil einer Außenoberfläche des Substrates (2), wobei das Material Nickel und Phosphor als Legierungsbestandteile enthält,
c) Beschichten zumindest eines Teils des mit Schritt b) bereitgestellten Halbzeugs (3) mittels einer physikalischen Gasphasenabscheidung.

## Beschreibung

Die Erfindung betrifft ein Verfahren zur Herstellung eines beschichteten Bauteils, ein Sanitärbauteil sowie eine Verwendung eines Nickel und Phosphor als Legierungselemente enthaltenden Materials. Die Erfindung kommt insbesondere bei der Herstellung dekorativer Oberflächen von Bauteilen für Sanitärprodukte, wie etwa Sanitärarmaturen zur Anwendung.

Um Substrate aus Kupfer und Kupferlegierungen mit einer PVD-Schicht und gebürsteter Optik für eine dekorative Anwendung mit funktionellem Charakter herzustellen, sind verschiedene Möglichkeiten bekannt. Es können zum Beispiel ein Bürsten des Substrats und eine anschließende PVD-Beschichtung erfolgen. Nachteile dieses Vorgehens bestehen darin, dass keine Korrosionsbeständigkeit gewährleistet und/oder die Farbe der PVD-Schicht durch das darunter liegende Substrat verändert werden kann.

Eine weitere Möglichkeit besteht in einem Vernickeln des Substrates aus Kupfer bzw. aus einer Kupferlegierung in einem galvanischen Bad (zum Beispiel Watts-Nickel, Satin-Nickel, Glanz-Nickel, Matt-Nickel) mit anschließendem Bürsten und PVD-Beschichten. Nachteile dieser Vorgehensweise sind eine ungenügende Korrosionsbeständigkeit des Nickels und, dass die Nickelschichten die Bürststruktur wieder einebnen und so die Oberfläche stark aufglänzen. Dies führt zu einem Verlust der gewünschten Bürstoptik.

Zur Verbesserung der Korrosionsbeständigkeit könnte zusätzlich zu dem Vernickeln auch ein Verchromen in einem galvanischen Bad erfolgen. Nachteile dieser Möglichkeit sind jedoch, dass es aufgrund der Härte der Chromschicht schwierig und zeitaufwändig ist eine gleichmäßige Bürstoptik zu erreichen. Es ist daher in der Regel notwendig nach dem Vernickeln und Verchromen mit stark abrasiven Pasten und einer Polierscheibe zu arbeiten. Das ist aufwendig. Zudem kann es an Stellen mit niedriger Chromschichtdicke dazu kommen, dass man durchbürstet und dadurch das darunter liegende Nickel oder sogar Messing freilegt. Dies kann wiederum zu Korrosionsproblemen führen.

Hiervon ausgehend ist es Aufgabe der vorliegenden Erfindung, die mit Bezug auf den Stand der Technik geschilderten Probleme zumindest teilweise zu lösen. Insbesondere sollen ein Verfahren, ein Sanitärbauteil und eine Verwendung angegeben werden, die es ermöglichen, möglichst kostensparend und effizient ein möglichst korrosionsbeständiges, beschichtetes Bauteil für sanitäre Anwendungszwecke bereitzustellen. Zudem sollen die erhaltenen Bauteile mit einer dekorativen Oberfläche bereitgestellt werden können.

Diese Aufgaben werden gelöst durch die Merkmale der unabhängigen Patentansprüche. Weitere vorteilhafte Ausgestaltungen der hier vorgeschlagenen Lösung sind in den abhängigen Patentansprüchen angegeben. Es ist darauf hinzuweisen, dass die in den abhängigen Patentansprüchen einzeln aufgeführten Merkmale in beliebiger, technologisch sinnvoller, Weise miteinander kombiniert werden können und weitere Ausgestaltungen der Erfindung definieren. Darüber hinaus werden die in den Patentansprüchen angegebenen Merkmale in der Beschreibung näher präzisiert und erläutert, wobei weitere bevorzugte Ausgestaltungen der Erfindung dargestellt werden.

Hierzu trägt ein Verfahren zur Herstellung eines beschichteten Bauteils bei, umfassend zumindest folgende Schritte:
a) Bereitstellen eines Substrates für das Bauteil, wobei das Substrat insbesondere aus Kupfer oder einer Kupferlegierung bestehen kann, wobei diese Kupferlegierung als Hauptlegierungselement Zink enthalten kann,
b) Bereitstellen eines Halbzeugs für das Bauteil, durch Aufbringen eines Materials auf zumindest einen Teil einer Außenoberfläche des Substrates, wobei das Material Nickel und Phosphor als Legierungsbestandteile, insbesondere (kontinuierlich) abgeschieden durch elektrolytische Beschichtung, enthält,
c) Beschichten zumindest eines Teils des mit Schritt b) bereitgestellten Halbzeugs mittels einer physikalischen Gasphasenabscheidung.

Das Verfahren dient insbesondere zur Herstellung von PVD-beschichteten Bauteilen mit dekorativer Oberfläche für Sanitärprodukte, wie etwa Sanitärarmaturen. Die Schritte a), b) und c) können zumindest einmal in der angegebenen Reihenfolge durchgeführt werden. Darüber hinaus ist denkbar, dass die Schritte a), b) und c) zumindest teilweise parallel ablaufen können. Weiterhin kann das Verfahren zur Herstellung eines hier auch beschriebenen Sanitärbauteils durchgeführt werden.

In Schritt a) erfolgt ein Bereitstellen eines Substrates für das Bauteil. Regelmäßig definiert das Substrat die Form des (fertigen) Bauteils. Bei dem Substrat handelt es sich in der Regel um einen metallischen Körper, wie etwa einen Messingkörper bzw. einen Körper, der aus Kupfer oder einer Kupferlegierung bestehen kann, wobei diese Kupferlegierung als Hauptlegierungselement Zink enthalten kann. Dieser kann beispielsweise die Form eines Rohres bzw. eines Bestandteiles eines Sanitärproduktes, wie etwa einer Sanitärarmatur, insbesondere eines Sanitärarmatur-Gehäuses aufweisen. Eine weitere Möglichkeit der Bereitstellung eines Substrates für das Bauteil kann darin bestehen, dass das Substrat eine Kupfer- oder Kupferlegierungsschicht aufweist, die auf einem metallischen Werkstoff bzw. Körper (z. B. Messing, Zinkdruckguss) oder auf einem polymeren Werkstoff bzw. Körper (z.B. Acrylnitril-Butadien-Styrol, ABS) aufgebracht wurde. Die Dicke der Kupfer- bzw. Kupferlegierungsschicht liegt vorteilhaft im Bereich von 3µm - 100µm. Besonders bevorzugt liegt die Dicke der Kupfer- bzw. Kupferlegierungsschicht im Bereich von 5µm - 60µm. Insbesondere ist das Substrat (im fertig beschichteten Zustand) bzw. das Bauteil dazu vorgesehen und eingerichtet zumindest abschnittsweise einen Teil einer Sichtoberfläche eines Sanitärproduktes, wie etwa einer Sanitärarmatur zu bilden. In diesem Zusammenhang kann das Bauteil zum Beispiel ein dekoratives Element des Sanitärproduktes bzw. der Sanitärarmatur bilden.

In Schritt b) erfolgt ein Bereitstellen eines Halbzeugs für das Bauteil, durch Aufbringen eines Materials auf zumindest einen Teil einer Außenoberfläche des Substrates, wobei das Material Nickel und Phosphor als Legierungsbestandteile enthält. Beispielsweise kann in Schritt b) ein Beschichten zumindest eines Teils der Außenoberfläche mit einer Nickel-Phosphor-Legierung erfolgen. Bevorzugt wird das Material direkt auf das Substrat aufgebracht. Dies bedeutet mit anderen Worten insbesondere, dass kein anderes Material, insbesondere keine andere Beschichtung zwischen der Außenoberfläche des Substrats und dem Nickel und Phosphor als Legierungsbestandteile enthaltenden Material vorgesehen ist. Anschließend kann eine Reinigung des Halbzeugs, insbesondere zur Vorbereitung des Schritts c) erfolgen.

In Schritt c) erfolgt ein Beschichten zumindest eines Teils des mit Schritt b) bereitgestellten Halbzeugs mittels einer physikalischen Gasphasenabscheidung. Dies bedeutet mit anderen Worten insbesondere, dass in Schritt c) eine PVD - (*Physical Vapour Deposition*)-Beschichtung auf zumindest einen Teil des Halbzeugs aufgebracht wird. Insbesondere wird in Schritt c) der Teil des Halbzeugs beschichtet, auf den zuvor in Schritt b) das Nickel und Phosphor als Legierungsbestandteile enthaltende Material aufgebracht wurde. Dies kann mit anderen Worten auch so beschrieben werden, dass in Schritt c) zumindest ein Teil der Außenoberfläche des in Schritt b) aufgebrachten Materials mittels einer physikalischen Gasphasenabscheidung beschichtet wird.

Dabei erfolgt die physikalische Gasphasenabscheidung bzw. PVD-Beschichtung in der Regel direkt auf das Halbzeug bzw. das Nickel und Phosphor als Legierungsbestandteile enthaltende Material. Dies bedeutet mit anderen Worten insbesondere, dass kein anderes Material, insbesondere keine andere Beschichtung zwischen dem Halbzeug und der physikalischen Gasphasenabscheidung bzw. PVD-Beschichtung vorgesehen ist. Insbesondere ist keine Chromschicht zwischen dem Halbzeug bzw. Nickel und Phosphor als Legierungsbestandteile enthaltenden Material und der physikalischen Gasphasenabscheidung bzw. PVD-Beschichtung vorgesehen.

Nach einer vorteilhaften Ausgestaltung wird vorgeschlagen, dass das Bauteil ein Sanitärbauteil ist. Beispielsweise kann es sich um ein Bauteil für eine Sanitärarmatur, wie etwa ein Rohr für eine Sanitärarmatur oder zumindest einen Teil eines Gehäuses einer Sanitärarmatur handeln. Alternativ oder kumulativ kann es sich bei dem Sanitärbauteil um einen Wasserführungsabschnitt handeln. Insbesondere ist zumindest ein Teil der Außenoberfläche dieses Wasserführungsabschnitts dazu vorgesehen und eingerichtet eine Sichtoberfläche einer Sanitäreinrichtung bzw. Sanitärarmaturzu bilden. Beispielsweise kann es sich bei dem Bauteil um ein Zinkdruckgussbauteil handeln, welches beispielhaft als Teil einer Sanitärarmatur oder eines (Sanitär-)Accessoires, wie z. B. Hebel, Gehäuse, Handtuchhaken etc. zum Einsatz kommen kann. Des Weiteren kann es sich bei dem Bauteil um ein Acrylnitril-Butadien-Styrol (ABS) Bauteil handeln, wie z. B. ein Brausengehäuse, Abdeckkappen, Halter, Kappen etc.

Nach einer weiteren vorteilhaften Ausgestaltung wird vorgeschlagen, dass das Substrat mit einem Material gebildet ist, das zumindest Kupfer oder Messing enthält. Bevorzugt ist das Substrat aus einem kupferhaltigen Werkstoff, wie zum Beispiel Messing gebildet. Somit kann das Substrat, insbesondere ein in dem Substrat gebildeter Kanal, in vorteilhafter Weise zur Führung von (Trink-)Wasser geeignet sein.

Nach einer weiteren vorteilhaften Ausgestaltung wird vorgeschlagen, dass an dem Substrat vor Schritt b) eine mechanische Oberflächenbearbeitung mit einem Werkzeug durchgeführt wird. Die mechanische Oberflächenbearbeitung kann beispielsweise in Schritt a) oder zwischen den Schritten a) und b) erfolgen. Dabei kann zumindest ein Teil der (Außen-)Oberfläche des Substrats mechanisch bearbeitet werden. Hierbei wird vorzugsweise das (Grund-)Material des Substrats, d.h. das (noch nicht beschichtete) Material des Substrats bzw. die Kupfer- oder Kupferlegierungsschicht des Substrats, mechanisch bearbeitet. Insbesondere wird in Schritt b) das Nickel und Phosphor als Legierungselemente enthaltende Material zumindest auf einen Teil der mechanisch bearbeiteten (Außen-)Oberfläche aufgebracht.

Bevorzugt dient die mechanische Oberflächenbearbeitung zur Verzierung bzw. Veredelung zumindest eines Teils der (Außen-)Oberfläche des Substrats (und damit letztlich des Bauteils), beispielsweise durch Einbringen einer Struktur in die Oberfläche. Die mechanische Oberflächenbearbeitung trägt insbesondere zur Herstellung einer dekorativen Oberfläche oder eines dekorativen Teils der Oberfläche des Bauteiles bei. In diesem Zusammenhang kann die Oberflächenbearbeitung ausreichend stark sein, um auch nach den sich anschließenden Schritten b) und c) noch von außen sichtbar zu sein. Aber selbst wenn eine vergleichsweise schwache Oberflächenbearbeitung vorgenommen werden sollte, kann ein besonderer Vorteil des Nickel und Phosphor als Legierungsbestandteile enthaltenden Materials zum Tragen kommen, nämlich, dass Nickel-Phosphor-Legierungsschichten im Wesentliche nicht einebnen, sodass die darunter liegende mechanisch bearbeitete Oberflächenstruktur nahezu nicht verändert wird.

Bei der mechanischen Oberflächenbearbeitung handelt es sich insbesondere um einen Poliervorgang, einen Schleifvorgang oder einen Mattiervorgang. Dementsprechend kann es sich bei dem Werkzeug um ein Polierwerkzeug, ein Schleifwerkzeug oder ein Mattierwerkzeug handeln. Als Mattierwerkzeug kann beispielsweise mindestens eine Bürste, wie etwa eine Fiberbürste zum Einsatz kommen. Mit dieser kann, zum Beispiel durch Längsbewegungen in einer bestimmten Richtung entlang der Oberfläche, die Oberfläche mattiert bzw. ein matter Effekt erzeugt werden. Dies kann mit anderen Worten insbesondere auch so beschrieben werden, dass eine Bürststruktur in zumindest einen Teil der (Außen-)Oberfläche des Substrats eingebracht wird. Eine entsprechend polierte oder mattierte Oberfläche stellt eine bevorzugte Variante einer dekorativen Oberfläche dar.

Bevorzugt erfolgt die mechanische Oberflächenbearbeitung hierbei maschinell (und nicht manuell), vorzugsweise durch rotierende Scheiben, zum Beispiel mittels mindestens eines Schleifbandes, mindestens eines Schleifringes, mindestens einer Mattierscheibe oder eines Mattierringes, mindestens eines Polierringes oder einer Polierscheibe oder entsprechenden Bürsten (zum Polieren, Schleifen oder Mattieren). Dadurch, dass hier das (unbeschichtete) Substrat selbst bzw. das (Grund-)Material des Substrats bzw. die Kupfer- oder Kupferlegierungsschicht des Substrats bearbeitet wird, kann vorteilhaft eine maschinelle mechanische Oberflächenbearbeitung erfolgen. Dies ist aufgrund des hohen Materialabtrags, der in der Regel mit maschinellen mechanischen Oberflächenbearbeitungen einher geht, bei der Bearbeitung von insbesondere mit Chrom vorbeschichteten bzw. verchromten Halbzeugen bzw. Substraten nicht möglich.

Nach einer weiteren vorteilhaften Ausgestaltung wird vorgeschlagen, dass das Nickel und Phosphor als Legierungselemente enthaltende Material in Schritt b) elektrolytisch (und insbesondere kontinuierlich) auf das Substrat abgeschieden wird. Dies bedeutet mit anderen Worten insbesondere, dass eine Schicht aus Nickel-Phosphor-Legierung auf dem Substrat elektrolytisch abgeschieden wird. Die so abgeschiedene Legierung ist vorteilhaft kontinuierlich (insbesondere ohne Unterbrechung durch ein Einbringen (Mitabscheiden) von Feststoffen, wie etwa Siliziumcarbid). In diesem Zusammenhang kann eine besonders vorteilhafte Variante des Verfahrens auch als ein Einsatz eines Nickel-Phosphor-Legierungselektrolyten auf einem gebürsteten Messingbauteil zusammengefasst werden.

Nach einer weiteren vorteilhaften Ausgestaltung wird vorgeschlagen, dass das in Schritt b) aufgebrachte Material eine Nickel-Phosphor-Legierung mit einem Massenanteil des Phosphors von mindestens 4 % (Gewichtsprozent), insbesondere mindestens 8 % ist. Mit einem entsprechenden Phosphorgehalt kann in vorteilhafter Weise eine Korrosionsbeständigkeit des Bauteils ermöglicht werden. In diesem Zusammenhang ist es vorteilhaft, wenn der Massenanteil des Phosphors im Bereich von 48 % bis 14 %, insbesondere 8 % bis 14 % liegt. Besonders bevorzugt liegt der Massenanteil des Phosphors im Bereich von 10 % bis 12 %. Dies kann mit anderen Worten auch so beschrieben werden, dass die abgeschiedene Nickel-Phosphor-Legierung einen Massenanteil des Phosphors von mindestens 4 %, vorzugsweise 4 % bis 14 %, insbesondere 8 % bis 14 %, besonders bevorzugt 10 % bis 12 % haben soll. Dies ermöglicht in besonders vorteilhafter Weise möglichst kostensparend und effizient ein möglichst korrosionsbeständiges, beschichtetes Bauteil für sanitäre Anwendungszwecke bereitzustellen.

Durch die Eigenschaften der abgeschiedenen Nickel-Phosphor-Legierung(-sschicht) ergeben sich in vorteilhafter Weise eine hohe Korrosionsbeständigkeit, auch mit der anschließenden PVD-Beschichtung. Deswegen wird insbesondere keine auf der Nickel-Phosphor-Legierungsschicht abgeschiedene elektrolytische Chromschicht benötigt. Da Nickel-Phosphor-Legierungsschichten Oberflächenstrukturen, auf die sie aufgebracht werden, in der Regel nicht einebnen, wird auch eine hier gegebenenfalls darunter liegende Bürststruktur nahezu (bzw. im Wesentlichen) nicht verändert.

Ein weiterer Vorteil der Nickel-Phosphor-Legierung kann darin gesehen werden, dass Aufgrund der vorteilhaft hohen Korrosionsbeständigkeit nur wesentlich geringere Schichtdicken (als bei herkömmlichen Beschichtungen aus Nickel und/oder Chrom) nötig sind. Ein weiterer Vorteil kann auch darin gesehen werden, dass eine ggf. erfolgende Reinigung vor der PVD-Beschichtung vereinfacht werden kann, da in der Regel keine Bearbeitungsreste auf der Ni-P Schicht vorhanden sind.

Ein Bürsten in Messing oder Kupfer bzw. in eine Kupferlegierungsschicht zur Erreichung einer gewünschten Bürststruktur kann bei der Ni-P Schicht in vorteilhafter Weise mit einfachen Fiberbürsten durchgeführt werden. Es sind in diesem Zusammenhang insbesondere keine Polierpasten/Polierscheiben-Kombinationen notwendig. Das ist insbesondere einfacher, sauberer und schneller. Da man direkt in das Material bürstet, können fehlerhaft gebürstete Teile vorteilhaft nachgearbeitet werden.

Nach einem weiteren Aspekt wird ein Sanitärbauteil vorgeschlagen, zumindest aufweisend:
- ein Substrat, das eine Form des Bauteils definiert,
- eine PVD-Beschichtung, die zumindest einen Teil einer Außenoberfläche des Bauteils bildet,
- eine zwischen dem Substrat und der PVD-Beschichtung liegende Zwischenschicht, die zumindest teilweise Nickel und Phosphor enthält.

Nach einer weiteren vorteilhaften Ausgestaltung wird vorgeschlagen, dass das Sanitärbauteil nach einem hier beschriebenen Verfahren hergestellt ist.

Nach einem weiteren Aspekt wird auch eine Verwendung eines Nickel und Phosphor als Legierungselemente enthaltenden Materials zur Vorbereitung eines Sanitärbauteil-Substrats auf eine anschließende physikalischen Gasphasenabscheidung vorgeschlagen.

Die im Zusammenhang mit dem Verfahren erörterten Details, Merkmale und vorteilhaften Ausgestaltungen können entsprechend auch bei dem hier vorgestellten Sanitärbauteil und/oder der Verwendung auftreten und umgekehrt. Insoweit wird auf die dortigen Ausführungen zur näheren Charakterisierung der Merkmale vollumfänglich Bezug genommen. Die hier vorgestellte Lösung sowie deren technisches Umfeld werden nachfolgend anhand der Figuren näher erläutert. Es ist darauf hinzuweisen, dass die Erfindung durch die gezeigten Ausführungsbeispiele nicht beschränkt werden soll. Insbesondere ist es, soweit nicht explizit anders dargestellt, auch möglich, Teilaspekte der in oder in Zusammenhang mit den Figuren erläuterten Sachverhalte zu extrahieren und mit anderen Bestandteilen und/oder Erkenntnissen aus anderen Figuren und/oder der vorliegenden Beschreibung zu kombinieren. Es zeigt schematisch:

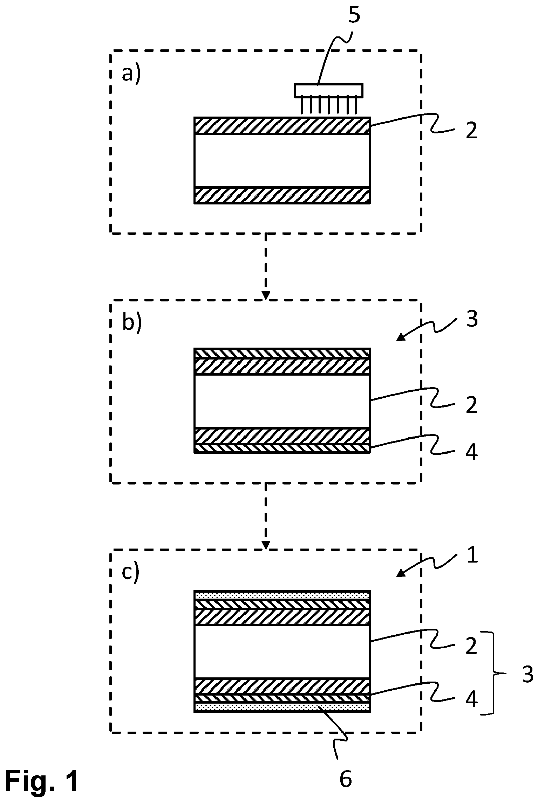

- Fig. 1:: einen beispielhaften Ablauf eines hier beschriebenen Verfahrens.

Fig. 1 zeigt schematisch einen beispielhaften Ablauf eines hier beschriebenen Verfahrens zur Herstellung eines beschichteten Bauteils 1. Bei dem Bauteil 1 kann es sich zum Beispiel um ein Sanitärbauteil, hier beispielhaft in der Form eines Rohres für eine Sanitärarmatur handeln. In Schritt a) erfolgt ein Bereitstellen eines Substrates 2 für das Bauteil 1. Das Substrat 2 ist hier beispielhaft mit Kupfer oder einem kupferhaltigen Werkstoff, wie etwa Messing gebildet ist. Weiterhin ist in dem Schritt a) betreffenden Block der Fig. 1 beispielhaft angedeutet, dass an dem Substrat 2 vor Schritt b), hier beispielhaft in Schritt a), eine mechanische Oberflächenbearbeitung mit einem Werkzeug 5 durchgeführt wird. Bei dem Werkzeug 5 handelt es sich hier beispielswiese um eine Bürste.

In Schritt b) erfolgt ein Bereitstellen eines Halbzeugs 3 für das Bauteil 1, durch Aufbringen eines Materials 4 auf zumindest einen Teil einer Außenoberfläche des Substrates 2. Bei diesem Teil handelt es sich hier beispielhaft um die Außenmantelfläche des Substrats 2. Weiterhin enthält das Material Nickel und Phosphor als Legierungsbestandteile. Beispielhaft wird das Material 4 in diesem Zusammenhang elektrolytisch auf das Substrat 2 abgeschieden. Ferner ist das aufgebrachte Material 4 hier zum Beispiel eine Nickel-Phosphor-Legierung mit einem Massenanteil des Phosphors von mindestens 4 %. Insbesondere liegt der Massenanteil des Phosphors im Bereich von 8 % bis 14 %. Die Legierung ist insbesondere kontinuierlich.

In Schritt c) erfolgt ein Beschichten zumindest eines Teils des mit Schritt b) bereitgestellten Halbzeugs 3 mittels einer physikalischen Gasphasenabscheidung. Bei dem so beschichteten Teil handelt es sich hier beispielhaft um die Außenmantelfläche des Halbzeugs 3. Bei der Beschichtung handelt es sich mit anderen Worten um eine PVD-Beschichtung.

Diese Schritte tragen dazu bei ein Sanitärbauteil 1 bereitzustellen, das zumindest ein Substrat 2, das eine Form des Bauteils 1 definiert, eine PVD-Beschichtung 6, die zumindest einen Teil einer Außenoberfläche des Bauteils 1 bildet, und eine zwischen dem Substrat 2 und der PVD-Beschichtung 6 liegende (kontinuierliche) Zwischenschicht 4, die zumindest teilweise Nickel und Phosphor enthält, aufweist.

Das dargestellte Verfahren veranschaulicht auch eine beispielhafte Verwendung eines Nickel und Phosphor als Legierungselemente enthaltenden Materials 4 zur Vorbereitung eines Sanitärbauteil-Substrats 2 auf eine anschließende physikalischen Gasphasenabscheidung. Insbesondere ist ein Einsatz eines Nickel-Phosphor-Legierungselektrolyten direkt auf einem gebürsteten kupferhaltigen Substrat (ABS, Zinkdruckguss) bzw. Werkstoff (Messing), mit beispielsweise anschließender Reinigung und PVD-Beschichtung gezeigt. Durch die Eigenschaften der abgeschiedenen Nickel-Phosphor-Legierungsschicht ergibt sich in vorteilhafter Weise eine hohe Korrosionsbeständigkeit, auch mit der anschließenden PVD Beschichtung.

Somit werden ein Verfahren, ein Sanitärbauteil und eine Verwendung angegeben, welche die mit Bezug auf den Stand der Technik geschilderten Probleme zumindest teilweise lösen. Insbesondere werden ein Verfahren, ein Sanitärbauteil und eine Verwendung angegeben, die es ermöglichen möglichst kostensparend und effizient ein möglichst korrosionsbeständiges, beschichtetes Bauteil für sanitäre Anwendungszwecke bereitzustellen. Zudem können die erhaltenen Bauteile mit einer dekorativen Oberfläche bereitgestellt werden.

### Bezugszeichenliste

- 1: Sanitärbauteil
- 2: Substrat
- 3: Halbzeug
- 4: Material
- 5: Werkzeug
- 6: PVD-Beschichtung

## Patentansprüche

1. Verfahren zur Herstellung eines beschichteten Bauteils (1), umfassend zumindest folgende Schritte:
a) Bereitstellen eines Substrates (2) für das Bauteil (1),
b) Bereitstellen eines Halbzeugs (3) für das Bauteil (1), durch Aufbringen eines Materials (4) auf zumindest einen Teil einer Außenoberfläche des Substrates (2), wobei das Material Nickel und Phosphor als Legierungsbestandteile enthält,
c) Beschichten zumindest eines Teils des mit Schritt b) bereitgestellten Halbzeugs (3) mittels einer physikalischen Gasphasenabscheidung.

2. Verfahren nach Anspruch 1, wobei das Bauteil (1) ein Sanitärbauteil (1) ist.

3. Verfahren nach Anspruch 1 oder 2, wobei das Substrat (2) mit einem Material gebildet ist, das zumindest Kupfer oder Messing enthält.

4. Verfahren nach einem der vorhergehenden Ansprüche, wobei an dem Substrat (2) vor Schritt b) eine mechanische Oberflächenbearbeitung mit einem Werkzeug (5) durchgeführt wird.

5. Verfahren nach einem der vorhergehenden Ansprüche, wobei das Nickel und Phosphor als Legierungselemente enthaltende Material (4) in Schritt b) elektrolytisch auf das Substrat (2) abgeschieden wird.

6. Verfahren nach einem der vorhergehenden Ansprüche, wobei das in Schritt b) aufgebrachte Material (4) eine Nickel-Phosphor-Legierung mit einem Massenanteil des Phosphors von mindestens 4 % ist.

7. Verfahren nach Anspruch 6, wobei der Massenanteil des Phosphors im Bereich von 4 % bis 14 % liegt.

8. Sanitärbauteil (1), zumindest aufweisend:
- ein Substrat (2), dass eine Form des Bauteils (1) definiert,
- eine PVD-Beschichtung (6), die zumindest einen Teil einer Außenoberfläche des Bauteils (1) bildet,
- eine zwischen dem Substrat (2) und der PVD-Beschichtung (6) liegende Zwischenschicht (4), die zumindest teilweise Nickel und Phosphor enthält.

9. Sanitärbauteil (1) nach Anspruch 8, wobei das Sanitärbauteil (1) nach einem Verfahren gemäß einem der Ansprüche 1 bis 7 hergestellt ist.

10. Verwendung eines Nickel und Phosphor als Legierungselemente enthaltenden Materials (4) zur Vorbereitung eines Sanitärbauteil-Substrats (2) auf eine anschließende physikalischen Gasphasenabscheidung.
